# FASCICULE DE BREVET EUROPEEN

(11) **EP 3 102 973 B1**
(45) Date de publication et mention de la délivrance du brevet: **25.03.2020**
(21) Numéro de dépôt: 15704763.0
(22) Date de dépôt: 06.02.2015
(51) Int. Cl.: G02B 6/42

(54) **PROCÉDÉ DE FABRICATION DE STRUCTURES DE COUPLAGE OPTIQUE VERTICAL**
VERFAHREN ZUR HERSTELLUNG VERTIKALER OPTISCHER KOPPLUNGSSTRUKTUREN
METHOD FOR MANUFACTURING VERTICAL OPTICAL COUPLING STRUCTURES

(30) Priorité: 07.02.2014 FR 1450962
(43) Date de publication de la demande: 14.12.2016
(73) Titulaire: CNAM Conservatoire National des Arts des Metiers, 75003 Paris (FR); Chambre de Commerce et d'Industrie de Région Paris Ile de France (ESIEE Paris), 93160 Noisy Le Grand (FR)
(72) Inventeur: POLLEUX, Jean-Luc, F-60710 Houdancourt (FR); ARAUJO-VIANA, Carlos, 77340 Pontaul-Combault (FR)
(74) Mandataire: Regimbeau
(86) Numéro de dépôt international: PCT/EP2015/052560
(87) Numéro de publication internationale: WO 2015/118131

(56) Documents cités:
- EP-A1- 1 722 258
- WO-A1-92/20004
- WO-A2-2011/002508
- OUCHI T ET AL: "Direct coupling of VCSELs to plastic optical fibers using guide holes patterned in a thick photoresist", IEEE PHOTONICS TECHNOLOGY LETTERS, IEEE SERVICE CENTER, PISCATAWAY, NJ, US, vol. 14, no. 3, 1 mars 2002 (2002-03-01), pages 263-265, XP011426665, ISSN: 1041-1135, DOI: 10.1109/68.986780 cité dans la demande

## Description

La présente invention concerne le domaine des structures de couplage optique entre composants optiques ou optoélectroniques. L'invention s'applique notamment à la connexion d'une matrice de fibres optiques à une matrice de photodétecteurs rapides, de petites dimensions, à éclairement vertical ou à une matrice de diodes laser rapides de petites dimensions, à cavité verticale émettant par la surface, c'est-à-dire de lasers à émission par la surface et à cavité verticale (« Vertical-Cavity Surface-Emitting Lasers » ou VCSEL) de manière collective et passive.

### ETAT DE LA TECHNIQUE

On connait des dispositifs de couplage destinés à la transmission d'un signal lumineux entre un faisceau de fibre optique émettrice et un autre faisceau de fibre optique réceptrice, ou un ou plusieurs composants optiques ou optoélectroniques, actifs ou passifs, tels que des connecteurs, des diodes électroluminescentes ou laser, etc, voir par example EP1722258.

Afin de minimiser les pertes de signal en entrée ou en sortie des fibres optiques dues à un désalignement optique, à une rétro-réflexion ou autre effet opto-géométrique, le dispositif de couplage doit réaliser un alignement précis de l'axe des fibres optiques et éviter une discontinuité d'indice de réfraction à l'interface entre le cœur de la fibre optique et le milieu extérieur. Le couplage d'une fibre optique et d'une diode laser à cavité verticale émettant par la surface (appelée par la suite VCSEL pour l'anglais Vertical-Cavity Surface-Emitting laser) nécessite, en général, un alignement au micron près pour les fibres monomodes à quelques microns près pour les fibres multimodes. De plus, l'encombrement du dispositif de couplage doit être réduit au maximum pour des raisons pratiques évidentes, et pour se conformer à la miniaturisation croissante des dispositifs optoélectroniques.

On connait des techniques d'alignement actives d'une fibre et d'un émetteur laser grâce à deux mécanismes d'orientation. L'émetteur laser produit un faisceau qui est orienté de manière active dans la fibre optique qui est également orientée de manière active. Les deux mécanismes d'orientation ont pour fonction d'aligner le laser et la fibre pour obtenir un rendement maximal. Lorsque l'alignement est obtenu, on fixe la fibre à l'émetteur laser par soudage ou collage. Cette technique d'alignement actif conduit à un coût élevé pour l'assemblage obtenu.

De plus les systèmes de couplage de l'art antérieur, par exemple à lentille de type boule, posent le problème d'un alignement à trois parties, à savoir le composant d'émission, le composant de réception, et la lentille elle-même. Il s'agit alors d'un alignement à six degrés de libertés.

Des techniques d'alignement passives ont également été proposées. Le document, « Direct Coupling of VCSELs to Plastic Optical Fibers Using Guide Holes Patterned in a Thick Photoresist », T. Ouchi, par exemple, décrit une méthode de couplage d'un VCSEL émettant par la face arrière et d'une fibre optique consistant à former un trou de guidage dans le substrat du VCSEL. Des trous de guidage sont percés dans le substrat qui porte les dispositifs et les fibres optiques sont glissées dans ces trous. Les trous de guidage peuvent être biseautés ('taper' en anglais) pour améliorer le guidage de la fibre.

Néanmoins, cette technique réalise un guidage de la fibre, mais n'assure le couplage optique que par contact direct, couplage dit « butt-coupling ». Aussi elle ne réalise pas de focalisation du faisceau optique et ne permet le couplage efficace ni d'un VCSEL de petite dimension ou divergent à la fibre, ni d'un VCSEL à une fibre dont le cœur est de dimension réduite telle que les fibres monomodes, ni d'une fibre à un photodétecteur de dimension plus petite que la fibre.

Les documents [GB1409793, EP1722258, US20080123198, WO2011/002508A2] font l'objet de structures de couplage optiques constituées de pièces mécaniques fixées les unes aux autres. Ces documents proposent un couplage passif de photodétecteurs ou de lasers sous la condition de grandes dimensions de ceux-ci, c'est-à-dire pour des dimensions souvent supérieures à 50µm. Il s'agit de réalisation de couplage d'une fibre à un dispositif émetteur ou récepteur unique pour le cas des documents [GB1409793, EP1722258, US20080123198], voire d'une fibre à un groupe de dispositifs d'émetteur ou récepteur optique dont le nombre est quantifié et limité (1, 2, 4, typiquement inférieur à 16) pour le brevet [WO2011/002508A2].

Aucun des documents cités ci-dessus ne propose une solution collective permettant la réalisation de structures de couplage entre une matrice N de fibres vers une matrice N de dispositifs optiques, sources ou détecteurs.

Il existe donc un besoin pour un dispositif de couplage simple, pouvant être réalisé de manière collective, facilement adaptable, de faible épaisseur capable de focaliser le faisceau optique et d'améliorer le taux de couplage sans nécessiter un alignement actif.

### EXPOSÉ DE L'INVENTION

Un but de l'invention est de permettre de coupler deux composants optiques ou optoélectroniques, tels qu'un laser de type VCSEL et une fibre optique, de manière simple et peu coûteuse, à savoir de manière collective et passive. Ce but est atteint dans le cadre de la présente invention, grâce à une structure de couplage optique vertical entre deux composants optiques ou optoélectroniques, la structure de couplage étant caractérisée en ce qu'elle comprend une partie de couplage de forme générale tronconique constituée d'un matériau présentant un indice de réfraction supérieur à l'indice de réfraction du milieu ambiant, généralement l'air, la partie de couplage présentant une première surface transversale destinée à être en contact avec la surface d'émission ou de réception d'un premier composant optique ou optoélectronique et une deuxième surface transversale destinée à être en contact avec la surface d'émission ou de réception d'un second composant optique ou optoélectronique.

L'invention permet le couplage des fibres optiques, notamment des fibres optiques monomodes ou multimodes. Etant donné les faibles rendements obtenus lors du couplage de fibres optiques monomodes, l'invention est particulièrement adaptée et avantageuse pour ce type de fibres optiques.

L'invention est avantageusement complétée par les caractéristiques suivantes, prises individuellement ou en l'une quelconque de leurs combinaisons techniquement possibles :
- le matériau de la partie de couplage présente un indice de réfraction compris entre 1,2 et 4,2 ;
- le matériau de la partie de couplage présente un indice de réfraction compris entre les indices de réfraction des surfaces d'émission ou de réception des deux composants optiques ou optoélectroniques ;
- le matériau de la partie de couplage est un polymère ;
- le matériau de la partie de couplage est une résine photosensible ;
- le matériau de la partie de couplage est en SU-8, benzocyclobutene, parylène, polyméthacrylate de méthyle ou Silicium ;
- la structure de couplage optique vertical comporte en outre une partie de support adaptée pour venir en appui sur un substrat recevant l'un des composants optiques afin de maintenir la partie de couplage en position de couplage par rapport à la surface d'émission ou de réception du composant optique ;
- la partie de support comprend un cadre adapté pour venir en appui sur le substrat et des bras de suspension reliant la partie de couplage au cadre, et s'étendant radialement à partir de la partie de couplage ;
- les bras de suspension sont de section transversale triangulaire, avec un sommet du triangle orienté du côté de la face tronquée de la partie de couplage ;
- la partie de support comporte en outre une structure de maintien de la fibre présentant en son centre un logement cylindrique adapté pour recevoir une extrémité de la fibre optique ;
- la structure de couplage optique vertical comporte en outre une couche de séparation entre la structure de maintien de la fibre et le support ;
- la partie de couplage est de forme tronconique de section circulaire ou rectangulaire.
- la partie de couplage et sa partie de support est réalisée en matrice, en une seule étape de fabrication de manière collective sur le substrat recevant une matrice de composants optiques ou optoélectroniques à coupler.

L'invention concerne un procédé de fabrication d'une structure de couplage optique vertical comme décrit plus haut fabriquée par exemple par lithographie, photolithographie, et/ou gravure physicochimique d'un substrat recevant l'un des composants optiques. Elle réalise ainsi un couplage collectif et passif.
En d'autres termes, la présente invention concerne un procédé de fabrication de structures de couplage optique vertical entre des premiers composants optiques ou optoélectroniques et des seconds composants optiques ou optoélectroniques, permettant de réaliser un dispositif de couplage collectif monobloc dite matrice, lesdites structures de couplage vertical étant réalisées:
- par dépôt ou report d'une couche principale sur un substrat comprenant des seconds composants optiques ou optoélectroniques dans une étape (i)
- par lithographie et/ou par gravure physico-chimique de la couche principale dans une étape (ii),
chaque structure de couplage optique vertical étant réalisée pour être située en regard et en contact d'un second composant optique situé dans le substrat,
la couche principale monobloc comportant des parties de couplage de forme générale tronconique constituées d'un matériau présentant un indice de réfraction supérieur à l'indice de réfraction de l'air;
les parties de couplage présentant chacune une première surface transversale d'extrémité destinée à être en contact avec la surface d'émission ou de réception (21) d'un premier composant optique ou optoélectronique, et une deuxième surface transversale d'extrémité qui est en contact avec la surface d'émission ou de réception du second composant optique ou optoélectronique.

On entend par couche principale, une couche qui peut être déformable comme de la résine ou une couche solide comme une plaque de silicium qui est reportée sur le substrat et gravée.

Cette couche principale est déposée sur tout le substrat et n'est pas logée dans un moule ou autre.

Le terme dépôt concerne aussi bien le dépôt d'une couche malléable sur le substrat que le report correspondant à la mise en place d'une plaque solide par exemple en silicium sur le substrat.

L'étape de lithographie et/ou par gravure physico-chimique de la couche principale est réalisée par photolithographie.

L'étape de lithographie et/ou par gravure physico-chimique de la couche principale permet de réaliser pour chaque structure de couplage optique verticale une partie de support équipée d'un cadre suspendu adapté pour venir en appui sur le substrat, et des bras de suspension reliant la partie de couplage au cadre.

Une deuxième couche B est déposée sur la couche principale, cette deuxième couche permettant de réaliser par lithographie et/ou par gravure physicochimique des structures de maintien destinées à recevoir un premier composant optique ou optoélectronique dans un logement cylindrique.

La couche principale est une résine photosensible ou une résine non photosensible.

La couche principale est réalisée en silicium.

Des techniques de photolithographie par empreinte et/ou de photolithographie par nano-empreinte sont utilisées pour réaliser la structure de couplage vertical.

La couche principale est usinée par des techniques de type gravure ionique réactive et/ou gravure ionique réactive profonde.

Le substrat est préalablement creusé au niveau de logements pour disposer des seconds composants, optiques ou optoélectroniques différents dans ces logements, en affleurement d'une surface supérieure du substrat; les seconds composants optiques électroniques ou optoélectroniques (3) étant reliés les uns aux autres par des pistes métalliques.

Les premier et second composants optiques ou optoélectroniques sont de dimensions inférieures à 20 µm.

La présente invention concerne aussi une structure de couplage optique verticale entre deux composants optiques ou optoélectroniques réalisée à partir du procédé défini plus haut.

La présente invention concerne aussi un ensemble comportant :
- un premier composant optique ou optoélectronique présentant une surface d'émission ou de réception, et ;
- un second composant optique ou optoélectronique présentant une surface d'émission ou de réception
- une structure de couplage vertical comme définie par l'une des revendications 11 à 17, comprenant une partie de couplage de forme générale tronconique constituée d'un matériau présentant un indice de réfraction supérieur à l'indice de réfraction de l'air et présentant une hauteur donnée;
la partie de couplage présentant une première surface transversale, présentant un premier diamètre et destinée à être en contact avec la surface d'émission ou de réception du premier composant optique ou optoélectronique ; et une deuxième surface transversale, présentant un deuxième diamètre, et destinée à être en contact avec la surface d'émission ou de réception du second composant optique ou optoélectronique ;
l'ensemble étant caractérisé en ce que les dimensions des première et deuxième surfaces transversales sont optimisées de façon à maximiser le recouvrement de la distribution transverse du champ optique de sortie du premier composant optique ou optoélectronique avec la surface d'émission ou de réception du second composant optique ou optoélectronique tout en permettant une variation de positionnement entre le premier composant optique ou optoélectronique et la première surface transversale, et entre le second composant optique ou optoélectronique et la deuxième surface transversale, et en ce que
pour un deuxième diamètre donné, à une longueur d'onde donnée d'un faisceau optique, le rapport entre la hauteur et le premier diamètre est déterminé de manière à assurer un couplage optique d'au moins 60% entre le premier composant optique ou optoélectronique et le second composant optique ou optoélectronique, pour une variation de désalignement entre les deux composants optiques ou optoélectroniques , d'au moins 5 micromètres, en plus ou en moins, par rapport à une position de couplage maximale entre les deux composants optiques ou optoélectroniques.

La présente invention concerne aussi une matrice comprenant plusieurs structures de couplage.

La présente invention concerne aussi un ensemble comprenant une matrice présentant plusieurs structures de couplage, une matrice de seconds composants optiques située dans un substrat et/ou une matrice de structures de maintien destinées à recevoir des premiers composants optiques, ces matrices étant en appui les unes avec les autres.

### DESCRIPTION DES FIGURES

D'autres objectifs, caractéristiques et avantages sortiront de la description détaillée qui suit en référence aux dessins donnés à titre illustratif et non limitatif parmi lesquels :
- la figure 1 représente une structure de couplage selon un mode de réalisation possible de l'invention ;
- la figure 2 représente une vue en coupe de la structure de couplage couplée à une fibre;
- la figure 3 représente une vue en coupe de la structure de couplage couplée à un composant optique ou optoélectronique;
- la figure 4 représente une vue en coupe de la structure de couplage couplant une fibre optique à un composant optique ou optoélectronique;
- la figure 5 représente plusieurs structures de couplage selon un mode de réalisation possible de l'invention couplées à un composant optique ou optoélectronique;
- la figure 6 représente une structure de couplage selon un mode de réalisation de l'invention présentant un logement pour le guidage de la fibre optique;
- la figure 7 représente la structure de couplage de la figure 6 couplée à une fibre optique, pour laquelle le cœur de fibre présente une largeur inférieure à celle de la partie supérieure de la partie de couplage tronconique (la fibre dans ce cas est utilisée comme émettrice du rayonnement optique) ;
- la figure 8 représente une structure de couplage selon un autre mode de réalisation de l'invention présentant une structure de maintien biseauté ;
- la figure 9 représente la structure de couplage de la figure 8 couplée à une fibre optique pour laquelle le cœur de fibre présente une largeur inférieure à celle de la partie supérieure de la partie de couplage tronconique (la fibre dans ce cas est utilisée comme émettrice du rayonnement optique).
- les figures 10a et 10b représentent une structure de couplage selon un autre mode de réalisation de l'invention ;
- la figure 11a illustre un procédé de lithographie permettant de réaliser une structure de couplage selon un mode de réalisation de l'invention ;
- la figure 11b illustre un procédé de lithographie permettant de réaliser une structure de couplage avec une structure de maintien de la fibre et des bras de suspension selon un mode de réalisation de l'invention ;
- la figure 12 représente les courbes de tolérance d'alignement sur le taux de couplage entre une fibre multimode et un photodétecteur dont la surface active de détection est un carré de 10µm de côté, pour d'une part, (partie de gauche) une structure de couplage circulaire de 25µm de grand diamètre, 25µm de haut et 10µm de petit diamètre et d'autre part, (partie de droite) une structure de couplage carré de 25µm de grand côté, 25µm de haut et 10µm de base ;
- la figure 13 illustre le positionnement des contacts électriques d'un composant optoélectronique sur une structure de couplage selon un mode de réalisation de l'invention,

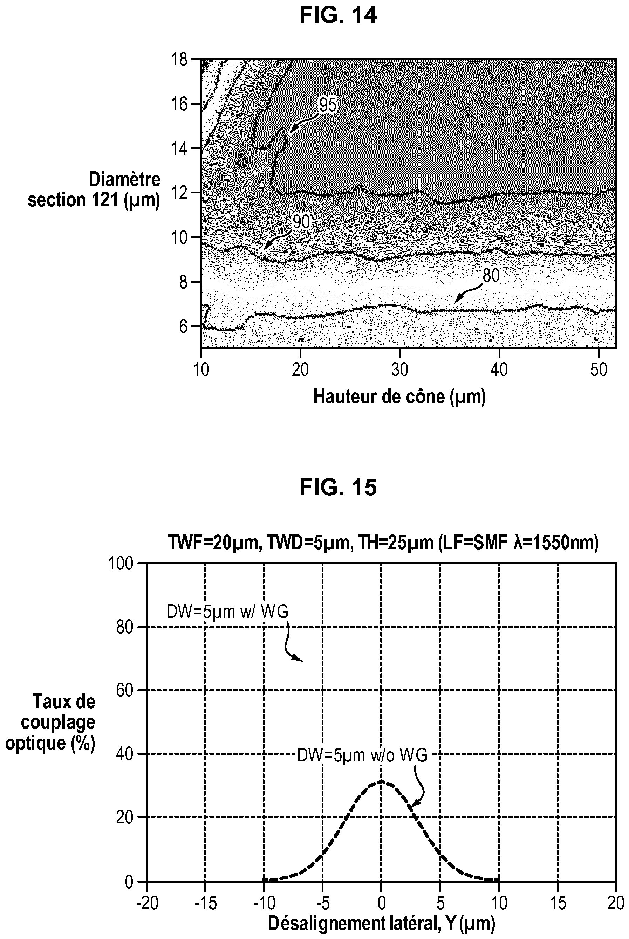

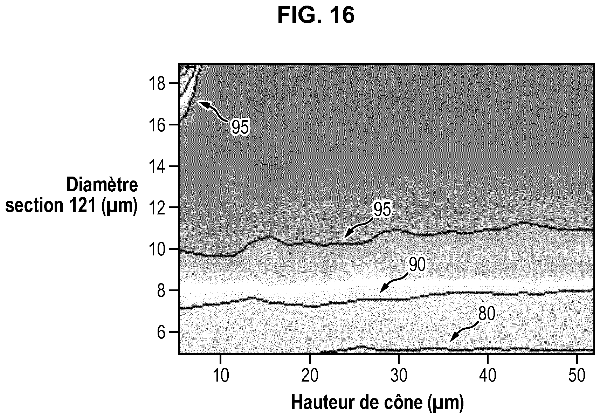

- la figure 14 illustre le cas d'un couplage entre une fibre optique monomode de 9µm de diamètre de cœur avec un photorécepteur de 5µm,
- La figure 15 illustre pour les mêmes conditions que celles de la figure 14 mais avec une dimension de 20µm de la base supérieure de section de la partie de couplage,
- Les figures suivantes 16 et 17 présentent les résultats obtenus dans le cas d'une section de 10µm de diamètre, compatible avec des photorécepteurs circulaires de 10µm de diamètre,
- La figure suivante représente les résultats expérimentaux préliminaires obtenus en utilisant une résine SU8 pour coupler une fibre monomode à la longueur d'onde de 1,550µnm de 9µm de diamètre de cœur.

### DESCRIPTION DÉTAILLÉE DE L'INVENTION

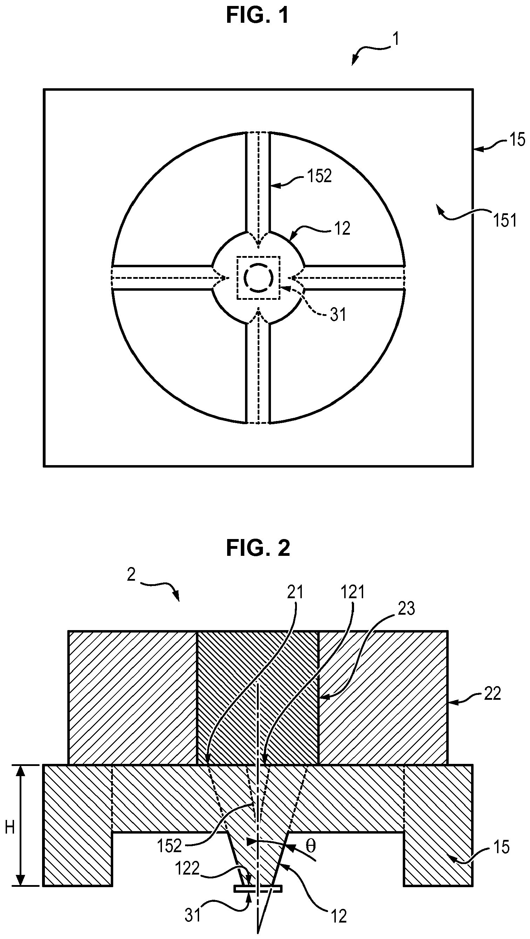

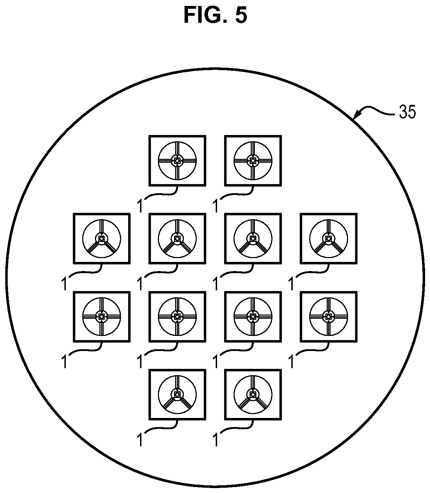

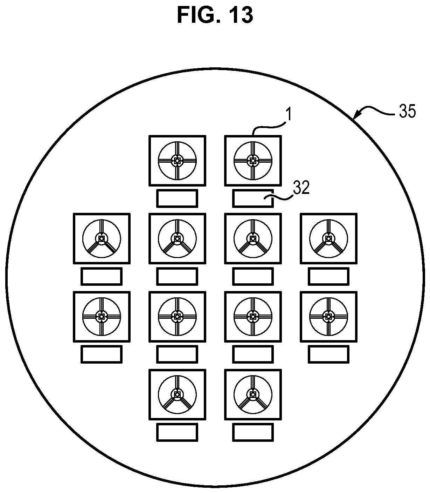

Sur la figure 1 on a représenté une structure de couplage optique vertical 1 élémentaire entre deux composants optiques ou optoélectroniques présentant des surfaces d'émission ou de réception de dimensions possiblement différentes, cette structure de couplage optique vertical étant réalisé N fois dans une matrice par le procédé selon l'invention, comme décrit figures 5 et 13.

Sur la figure 2, le premier composant optique ou optoélectronique est une fibre optique et le second un VCSEL.

On entend par couplage optique « vertical », vertical par rapport au plan du substrat sur lequel est réalisée la structure de couplage, qui est celui également celui de la structure de maintien de la fibre.

Une fibre optique à saut d'indice est constituée d'un cœur 23 cylindrique transparent d'indice constant N₁ entouré par une gaine 22 concentrique d'indice N₂ < N₁. Le cœur 23 est par exemple en silice avec un indice de réfraction de N₁ = 1,456 et un diamètre de cœur de 9 µm et la gaine 22 en silice avec un indice de réfraction de N₂ = 1,410 et un diamètre de 125 µm. Le cœur 23 d'une fibre optique monomode a typiquement un diamètre de 9 µm alors qu'un VCSEL présente une surface d'émission de diamètre d'environ 8 à 12µm. L'invention est particulièrement avantageuse pour le couplage à des lasers ou des photodétecteurs de dimensions inférieures, typiquement de 1 à 10µm.

La structure de couplage 1 comprend une partie de couplage 12 de forme générale tronconique définissant un volume rempli d'un matériau présentant un indice de réfraction supérieur à celui du milieu ambiant, le milieu ambiant étant généralement l'air.

La partie de couplage 12 est un cône tronqué par un plan perpendiculaire à son axe de révolution.

Le terme 'tronconique' peut être élargi par abus de langage à un prismoide, à une pyramide tronquée, à un convergent reliant deux surfaces planes parallèles et de tailles différentes.

En référence à la figure 2, la base du cône 121, qui est la face perpendiculaire à l'axe de révolution de plus grande surface est destinée à être mise en contact avec la surface d'émission ou de réception 21 d'un second composant optique ou optoélectronique 2.

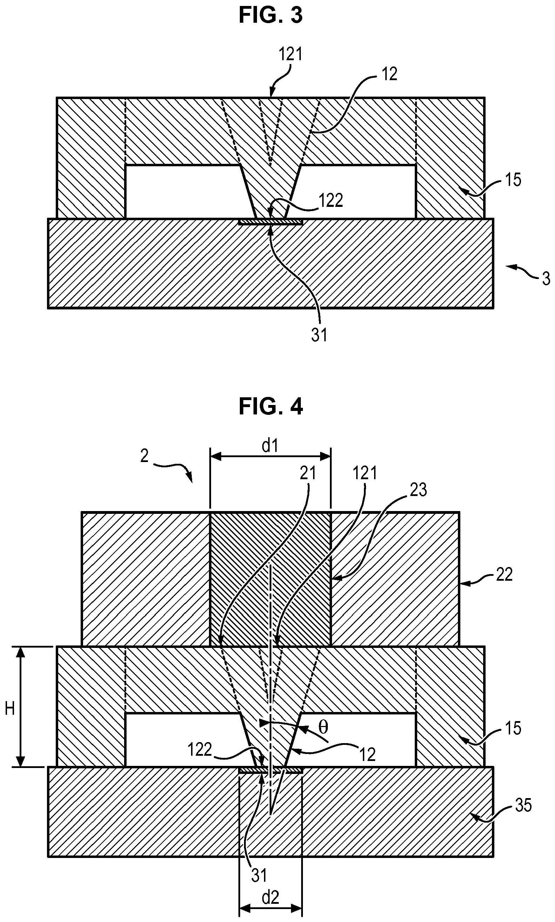

En référence à la figure 3, la face tronquée 122, qui est la face perpendiculaire à l'axe de révolution de plus petite surface, est destinée à être mise en contact avec la surface d'émission ou de réception 31 d'un premier composant optique ou optoélectronique 3.

L'aire de la base du cône 121 est généralement inférieure à l'aire de la surface d'émission ou de réception 21 du premier composant 2. De même la face tronquée 122 du cône présente une aire inférieure ou égale à celle de la surface d'émission ou de réception 31 du deuxième composant 3. De plus, la base du cône 121 est propre à être recouverte entièrement par la surface d'émission ou de réception 21 du premier composant 2. De même, la face tronquée 122 du cône est propre à être recouverte par la surface d'émission ou de réception 31 du deuxième composant 3.

En référence aux figures 2, 3 et 4, lors du couplage entre une fibre optique 2 et un VCSEL 3, la surface d'émission 31 du VCSEL est accolée contre la face tronquée 122, tandis que le cœur 23 de la fibre optique 2 est accolé contre la base 121 du cône, la gaine 22 de la fibre venant en appui contre la structure de support 15. La base 121 du cône présente une section de dimension inférieure à celle du cœur 23 de la fibre. Dans le cas d'un VCSEL, la face tronquée 122 du cône présente une superficie supérieure ou égale à la surface d'émission du VCSEL.

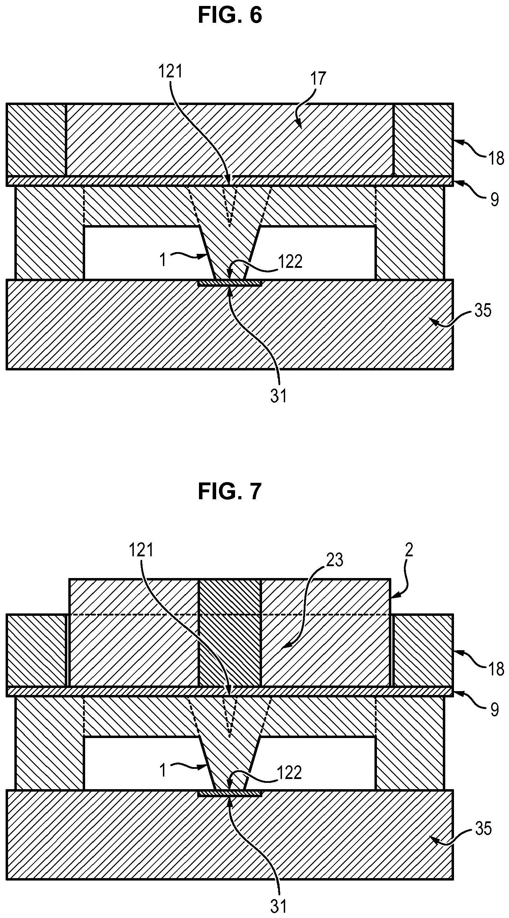

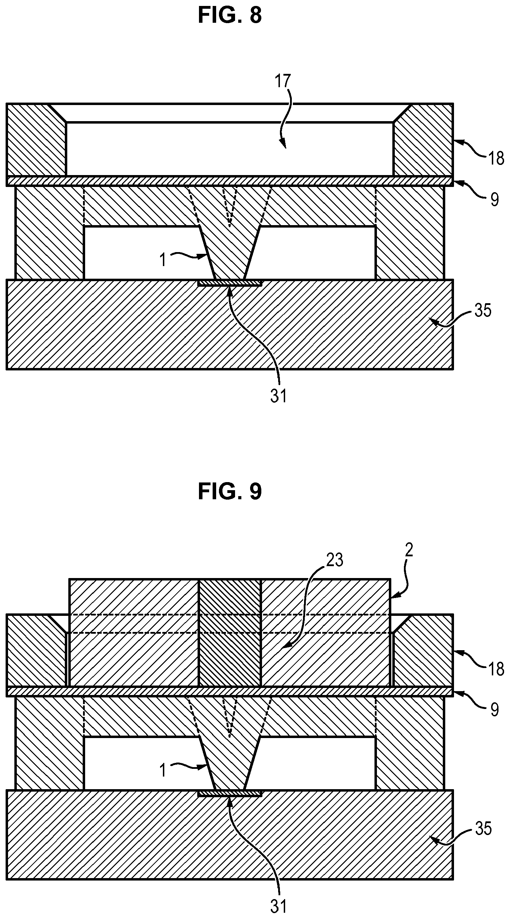

Dans le cas d'un photodétecteur, la face tronquée 122 doit être inférieure ou égale à la surface du photodétecteur et la base supérieure 121 du cône est supérieure ou égale à celle du cœur de fibre 23 qui émet le rayonnement comme illustré sur les figures 7 et 9.

L'indice de réfraction de la partie de couplage 12 doit être supérieur à l'indice de réfraction du milieu ambiant, par exemple dans le cas où le milieu ambiant est de l'air, l'indice de réfraction de la partie de couplage 12 doit être supérieur à 1. De manière préférée, l'indice de réfraction de la partie de couplage 12 doit être élevé afin de permettre un meilleur maintien des angles dans le cône d'acceptance de la fibre. Ainsi, l'indice de réfraction de la partie de couplage 12 doit être supérieur à 1, de préférence supérieur à 2 et de façon entre plus préférée supérieur à 3.

Par ailleurs, l'écart entre l'indice de réfraction de la partie de couplage 12 et les indices de réfraction des matériaux formant les surfaces d'émission ou de réception 21 et 31 doivent être faibles afin de minimiser les pertes par réflexion. Ainsi, l'indice de réfraction de la partie de couplage 12 est compris entre les indices de réfraction des matériaux formant les surfaces d'émission ou de réception 21 et 31 des deux composants optiques ou optoélectroniques 2 et 3 à 20% près et avantageusement 10% près. Dans le cas du couplage entre une fibre optique 2 et un VCSEL 3, l'indice de réfraction du cœur de la fibre étant typiquement de l'ordre de 1,5 et celui du matériau de la surface d'émission du VCSEL de l'ordre de 3,5, l'indice de réfraction de la partie de couplage 12 est donc compris entre 1,20 et 4,20 ; de préférence entre 1,35 et 3,85. La partie de couplage 12 est par exemple en polymère et préférentiellement en résine photosensible.

Dans le cas où les deux composants optiques 2 et 3 présentent des surfaces d'émission ou de réception circulaires, la partie de couplage 12 est avantageusement de forme tronconique de section circulaire. Dans le cas où l'un des composants optiques présente une surface d'émission ou de réception rectangulaire, la partie de couplage 12 peut être de section rectangulaire. Par ailleurs, dans le cas où la lumière transmise présente un axe de polarisation privilégié, la partie de couplage 12 présente avantageusement une section rectangulaire ou elliptique orientée de manière à conserver l'axe de polarisation privilégié.

On entend par « de forme générale tronconique » une structure ayant la forme d'une portion de cône comprise entre un plan parallèle à sa base et la base de celui-ci, un cône étant un volume défini par une génératrice, passant par un point fixe appelé sommet et un point variable décrivant une courbe plane fermée. La génératrice est une droite ou une ligne courbe de courbure inférieure à 5%.

Ce terme inclut notamment les formes tronconiques à section circulaire, rectangulaire, carrée, elliptique. La forme générale tronconique peut être en partie creuse mais elle est de préférence pleine.

Les dimensions des sections de contact 121 et 122 sont optimisées de façon à maximiser le recouvrement de la distribution transverse du champ optique de sortie du premier composant avec la surface de réception du second composant.

L'angle θ et la hauteur H du cône sont déterminés de manière à contenir la divergence du faisceau de sortie du composant optique d'émission, et ainsi maximiser l'adaptation d'angle d'acceptance et de mode entre le composant d'émission et le composant de réception.

Des simulations électromagnétiques doivent permettre d'optimiser les dimensions et le profil de la section conique, en fonction des modes émis par le composant d'émission et la géométrie du composant de réception. De telles optimisations peuvent être réalisées grâce à des logiciels bien connus de l'homme du métier tels que le logiciel RSoft.

Dans le cas où le composant 3 est un photodétecteur rapide de section carré de 10µm de côté et où le composant 2 est une fibre optique multimode de 50µm de diamètre de cœur, émettant un faisceau optique à la longueur d'onde de 850nm, la structure de couplage 1 est avantageusement réalisée en polymère photosensible SU-8 avec une section carrée, une face tronquée 122 de 10µm de côté, une hauteur H supérieure à 25µm et une base 121 de côté compris entre 1,17xH+3,7µm et 50µm. La structure de couplage 1 permet avantageusement, dans cette configuration, d'augmenter le coefficient de couplage de la fibre au photorécepteur, tout en relâchant les contraintes d'alignement de la fibre optique.

Dans le cas où le composant 3 est un photodétecteur rapide de section carré de 10µm de côté et où le composant 2 est une fibre optique monomode de 9µm de diamètre de cœur, émettant un faisceau optique à la longueur d'onde de 850nm, la structure de couplage 1 est avantageusement réalisée en polymère photosensible SU-8 avec une section carrée, une face tronquée 122 de 10µm de côté, une hauteur H variable et une base 121 de 15µm de côté. La structure de couplage 1 permet avantageusement, dans cette configuration, de relâcher les contraintes d'alignement de la fibre optique et éventuellement de réduire les réflexions à l'interface par rapport à une solution de couplage par contact direct.

Dans le cas où le composant 3 est un VCSEL à haut débit de diamètre d'ouverture optique D, typiquement 8µm, émettant un faisceau optique à la longueur d'onde de 850nm, et où le composant 2 est une fibre optique multimode de 50µm de diamètre de cœur, la structure de couplage 1 est avantageusement réalisée en polymère photosensible SU-8 avec une section circulaire, une face tronquée 122 de 7 à 9µm de diamètre, une hauteur H variable proche de 30µm et un angle entre la verticale et la génératrice de la section conique, compris entre -5° et +5°, permettant de déterminer la dimension de base 121 ainsi comprise entre 4 et 12µm pour D valant 8µm. La structure de couplage 1 permet avantageusement, dans cette configuration, d'augmenter le coefficient de couplage du VCSEL à la fibre multimode, en réduisant la divergence du faisceau à l'entrée de la fibre optique, tout en relâchant les contraintes d'alignement de la fibre optique. Elle permet également de maintenir un taux de couplage élevé pour des VCSEL de taille plus réduite, typiquement de quelques micromètres de diamètre d'ouverture optique.

Dans le cas où le composant 3 est un VCSEL à haut débit de diamètre d'ouverture optique de 8µm, émettant un faisceau optique à la longueur d'onde de 850nm, et où le composant 2 est une fibre optique monomode de 9µm de diamètre de cœur, la structure de couplage 1 est avantageusement réalisée en polymère photosensible SU-8 avec une section circulaire, une face tronquée 122 de 7 à 9µm de diamètre, une hauteur H comprise entre 30µm et 50µm et une base 121 de diamètre compris entre 4µm et 9µm. La structure de couplage 1 permet avantageusement, dans cette configuration, de maintenir un coefficient de couplage à la fibre élevé, par la réduction de la divergence du faisceau optique à l'entrée de la fibre optique, tout en relâchant les contraintes d'alignement de la fibre optique par rapport aux solutions conventionnelles.

La structure de couplage 1 comporte en outre une partie de support 15 adaptée pour venir en appui sur un substrat 35 recevant l'un des composants optiques 3 afin de maintenir la partie de couplage 12 en position de couplage par rapport à la surface d'émission ou de réception du composant optique 3. La partie de support 15 comprend un cadre 151 adapté pour venir en appui sur le substrat 35 et des bras de suspension 152 reliant la partie de couplage 12 au cadre 151, et s'étendant radialement à partir de la partie de couplage 12. La structure de couplage 1 comporte avantageusement trois ou quatre bras de suspension 152 disposés à angle égal autour de la partie de couplage 12. En référence à la figure 5, dans le cas ou plusieurs composants optiques ou optoélectroniques sont disposés sur un même substrat 35, plusieurs structures de couplage 12 peuvent être juxtaposées pour réaliser un couplage collectif. La présence de la partie de support 15 renforce la solidité de la structure de couplage 1 et lui évite de s'affaisser.

Dans le cas du couplage entre une fibre optique 2 et un VCSEL 3, le cadre 151 présente une section transversale (perpendiculaire à l'axe du cône tronqué) ayant un contour externe rectangulaire et un contour interne circulaire. Les bras de suspension 152 sont avantageusement de section transversale (section perpendiculaire à une direction longitudinale du bras) triangulaire, avec un sommet du triangle orienté du côté de la face tronquée de la partie de couplage 12, de manière à limiter les pertes par transmission à l'interface entre la partie de couplage 12 et les bras de suspension 152.

En référence aux figures 6 et 7, dans le cas où le premier composant optique ou optoélectronique 2 est une fibre optique, et le second 3 un VCSEL, la structure de couplage 1 est avantageusement complétée par une structure de maintien de la fibre 18 présentant en son centre un logement cylindrique 17 adapté pour recevoir une extrémité de la fibre optique 2, de manière à fixer et ajuster la position de la fibre optique 2 en alignement sur la structure de couplage 1. Une couche optionnelle de séparation 9 est insérée entre la structure de maintien de la fibre 18 et le support 15 de façon à garantir l'étanchéité et le contrôle de la nature du milieu extérieur, généralement de l'air, autour de la structure de couplage 151.

La couche optionnelle de séparation 9 est généralement faite de Silicium, d'Oxyde de Silicium, de Nitrure de Silicium, de Verre, de Parylène, de Polymère ou de résines par exemple de type SU8, BCB, PMMA.

La structure de maintien de la fibre 18 est généralement faite de Silicium ou de polymère.

Le positionnement de la partie de couplage 12 et des composants optiques 2 et 3 peut être réalisé avec ou sans pression. Avantageusement, la structure de couplage 1 est réalisée dans un matériau présentant un caractère adhésif (par exemple SU8, BCB) qui permet son maintien en position par pression contre le composant optique.

La structure de couplage 1 permet de confiner un faisceau optique émis par un composant optique ou optoélectronique présentant une surface d'émission de diamètre supérieure vers un composant optique ou optoélectronique présentant une surface de réception de diamètre inférieur. La structure proposée permet notamment de coupler un photodétecteur rapide de dimension réduite, typiquement de quelques micromètres, à une fibre optique multimode, typiquement de 50µm de diamètre de cœur, avec un rendement supérieur à ceux obtenus par les méthodes jusqu'ici proposées et ce avec une structure de couplage simple pouvant être réalisée directement par lithographie du substrat du photodétecteur, ce qui permet d'envisager un couplage collectif ainsi que des précisions requises d'alignement avec la fibre relâchées.

La structure de couplage 1 permet également de confiner un faisceau optique émis par un composant optique ou optoélectronique présentant une surface d'émission de diamètre inférieur vers un composant optique ou optoélectronique présentant une surface de réception de diamètre supérieur. La structure proposée permet notamment de coupler un VCSEL à une fibre optique monomode ou multimode avec un rendement supérieur à ceux obtenus par les méthodes jusqu'ici proposées et ce avec une structure de couplage simple pouvant être réalisée directement par lithographie du substrat du VCSEL, ce qui permet d'envisager un couplage collectif ainsi que des précisions requises d'alignement avec la fibre relâchées.

La structure de couplage vertical 1 est avantageusement complétée par une structure de maintien de la fibre 18. Cette structure de maintien 18 peut être réalisée dans une pièce complémentaire ou dans le volume du matériau 1.

Les étapes de réalisations de la matrice comprenant plusieurs dispositifs de couplage dépendent du matériau choisi. Deux cas sont possibles : le cas où le matériau est une résine photosensible, et le cas où le matériau doit être usiné par des techniques de microélectronique (Silicium, résine non photosensible).

Dans le cas où le matériau est une résine photosensible (SU8, BCB, etc.), le procédé consiste alors à contrôler les temps de développement et d'insolation aux ultra-violets (UV) afin de régler les flancs du motif polymérisé. Une pente peut être obtenue et son inclinaison optimisée par des conditions de sur-/sous-exposition et de sur-/sous-développement. Des techniques de lithographie par empreinte (ou IL pour Imprint-Lithography en anglais) et lithographie par nano-empreinte (ou NIL pour Nano-Imprint-Lithography en anglais) peuvent être alternativement exploitées.

Dans le cas où le matériau doit être usiné par des techniques de microélectronique (Silicium, résine non photosensible), des procédés de type gravure ionique réactive (ou RIE pour Reactive Ion Etching en anglais) et gravure ionique réactive profonde (ou DRIE pour Deep Reactive Ion Etching en anglais) sont avantageusement utilisés pour contrôler les flancs de gravure. La technique DRIE sur Silicium permet notamment un contrôle précis des flancs, sur des formes inclinées rectilignes, d'angle positif ou négatif, ou sur des formes courbes.

Pour des matériaux de type résine, des techniques de lithographie par empreinte (ou IL pour Imprint-Lithography en anglais) et lithographie par nano-empreinte (ou NIL pour Nano-Imprint-Lithography en anglais) peuvent être alternativement exploitées.

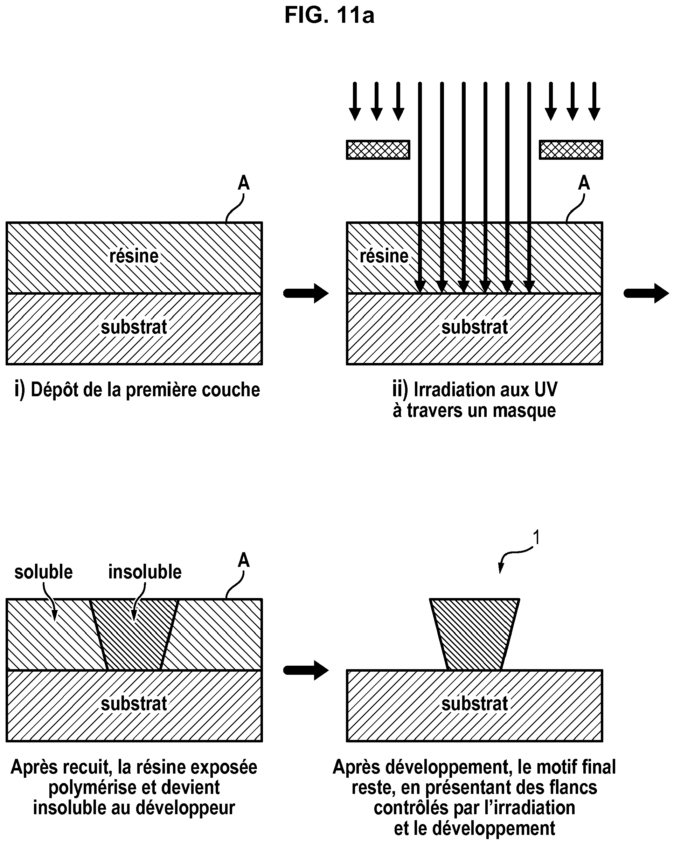

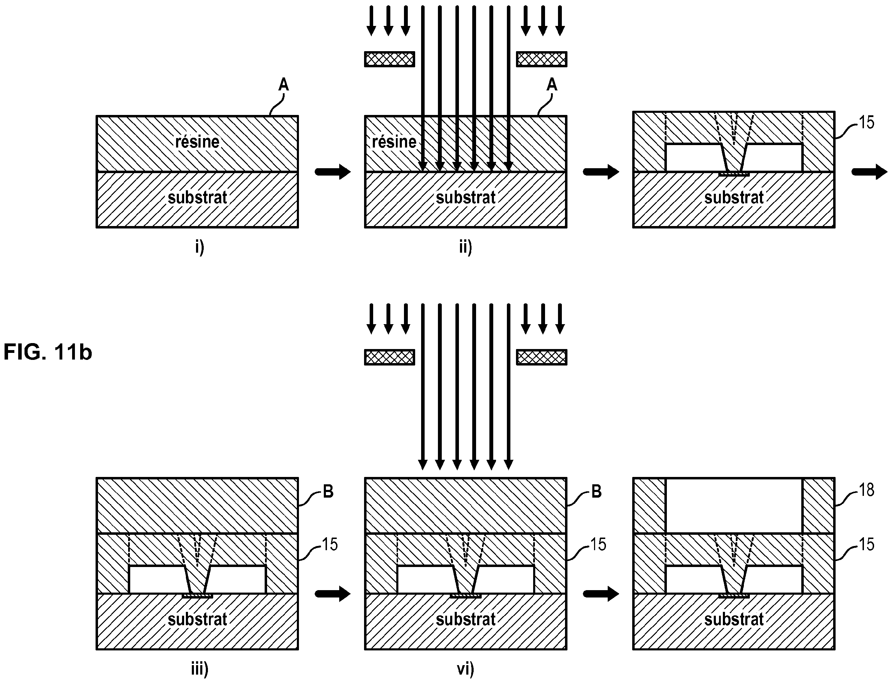

Le procédé de réalisation par photolithographie est par exemple réalisé comme décrit ci-dessous en référence à la figure 11.

Le substrat du VCSEL est recouvert d'une couche de résine photosensible est irradié, lors d'une première irradiation, en utilisant un masque, de sorte à ce que la partie exposée à la lumière polymérise. Après traitement de recuit, la partie polymérisée devient insoluble au révélateur tandis que la partie de résine photosensible non exposée reste soluble. Après dissolution de la partie de la résine photosensible soluble, il ne reste que la partie de résine photosensible exposée lors de la première irradiation.

La structure de couplage optique vertical 1 peut également être réalisée en plusieurs pièces assemblées par compression ou collage (collage polymère dans le cas de matériau photosensible). La structure de couplage optique vertical 1 est alternativement réalisée en un seul bloc. La réalisation monobloc peut être réalisée soit par combinaison des techniques de photolithographie et de gravure RIE, soit par DRIE seule (cas du Silicium), soit par combinaison de technique de photolithographie et NIL.

En référence à la figure 13, la structure de couplage vertical 1 ne masque pas les contacts électriques 32 du composant optoélectronique à coupler. Les électrodes de celui-ci sont situées en dehors de la partie de support 15, soit par éloignement des contacts électriques, soit par dimensionnement adéquat de la partie de support 15.

Les contacts électriques 32 du composant optoélectronique à coupler peuvent être pris selon diverses techniques usuelles et notamment des techniques de puce retournée (ou flip-chip en anglais), des techniques de thermocompression, des techniques de câblage par fil (ou wire-bonding en anglais) ou des techniques d'inclusion et prise de contact par photolithographie.

Les techniques de puce retournée et de thermocompression nécessitent que le substrat de report pour la prise d'interconnections dispose d'une ouverture de façon à laisser passer la fibre au travers. Ce substrat peut être commun au substrat dans lequel le logement cylindrique est réalisé, qui peut être ainsi un substrat de report (ou interposer en anglais) et disposer lui-même des interconnexions électriques. Cette approche s'insère donc dans la démarche d'interconnexion 3D.

En termes de dimension, si la structure d'ancrage supporte l'intégralité de la fibre optique, sa dimension est de l'ordre de 62,5µm de rayon. La distance d'un VCSEL à ses contacts électriques est généralement supérieure à cette dimension. Il est néanmoins possible en utilisant des techniques d'inclusion et de prise de contact par photolithographie de permettre que les contacts du composant optoélectronique soient en dessous du logement de la fibre. Cette option pourra permettre une plus grande densité de réalisation des VCSEL et photodétecteurs.

Le positionnement de la fibre se fait mécaniquement de manière passive. Il convient alors d'optimiser la structure de maintien 18 de la fibre. La fibre sera amenée par une méthode de report mécanique (appelé en anglais pick-and-place) ou automatisé ou manuel. Les appareils réalisant cette opération peuvent avoir une précision d'alignement à 1µm près, ce qui est très largement suffisant. En référence aux figures 8 et 9, la structure de maintien 18 présente avantageusement une forme biseautée sur sa partie supérieure, ce qui facilite avantageusement le glissement de la fibre dans son logement pour réduire les contraintes sur les appareillages de positionnement, voir permettre des positionnements manuels. En ce sens, il n'y pas d'alignement à réaliser. Celui-ci est réalisé de manière automatique et complètement passive par la structure elle-même.

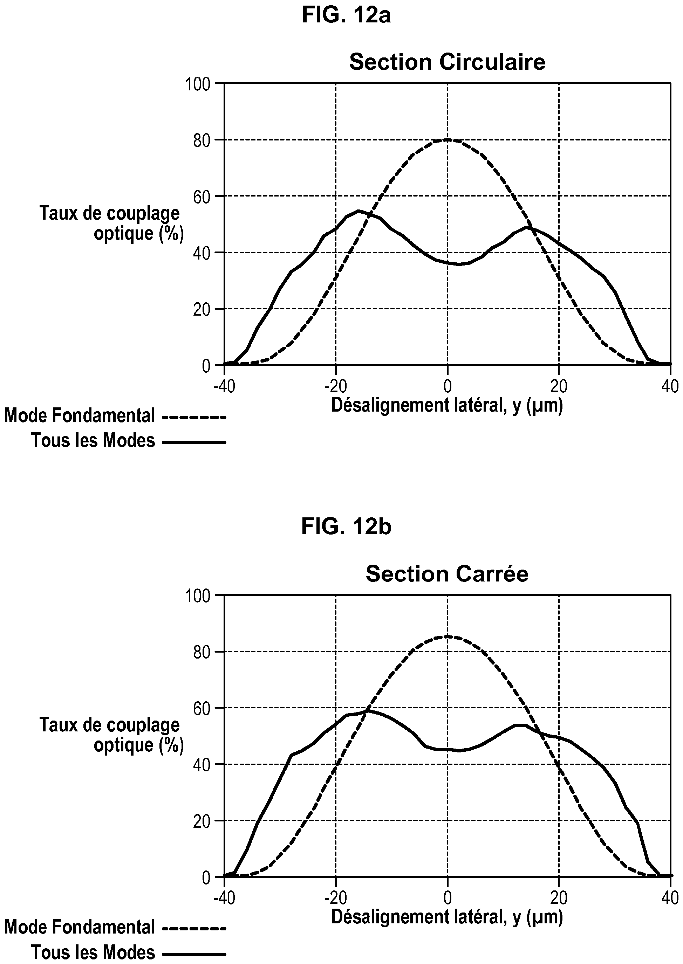

En référence à la figure 12, en tenant compte de l'alignement par photolithographie de la structure de couplage 1 sur le photodétecteur, la précision sera typiquement de +/-1µm, conduisant à un respect quasi intégral du taux maximal. L'alignement à la fibre est par contre obtenu différemment (guidage dans une fente). Pour un couplage entre une fibre optique multimode de 50µm de diamètre de cœur et un photodétecteur dont la surface active est de 10µm de côté, il ressort que l'alignement de la fibre pourra être toléré à +/-10µm pour un couplage supérieur à 70% sur le mode fondamental, et dans tous les cas supérieur à 40%. D'autres techniques conventionnelles utilisant des lentilles sphériques ont pu démontrer un taux de couplage maximal de 40% sur une dimension de photodétecteur de 10µm de côté, avec une distribution modale de la fibre réduite (utilisation d'un laser à 5 modes transverses, longueur de fibre 30cm sans brasseurs de modes ni coupleurs). La technique proposée apporte donc un avantage qualitatif important sur le taux de couplage, en même temps qu'elle apporte une solution passive et collective.

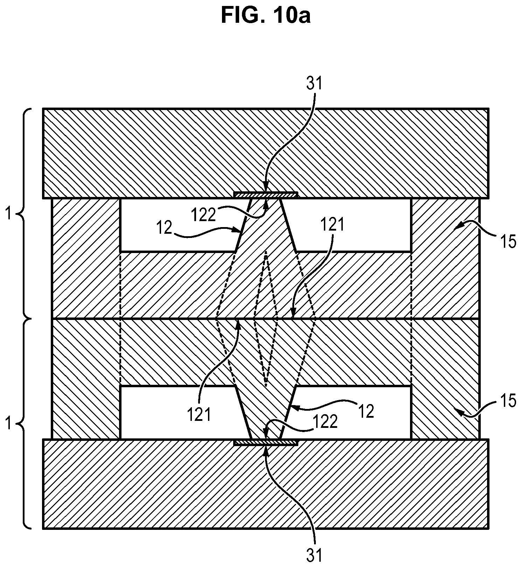

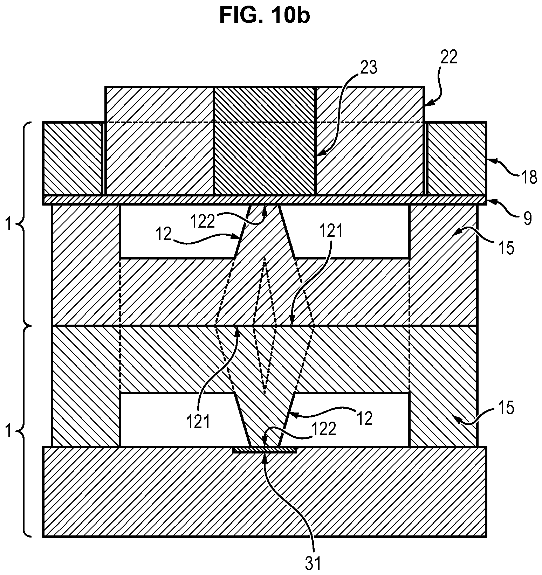

En référence à la figure 10-a), deux structures de couplage peuvent être associées. La base du cône 121 d'une première structure de couplage 1 et la base du cône 121 d'une seconde structure de couplage 1 sont accolées et la surface d'émission ou de réception 31 du premier composant optique ou optoélectronique est accolé à la face tronquée 122 de la première structure de couplage 1 tandis que la surface d'émission ou de réception 31 du second composant optique ou optoélectronique est accolé à la face tronquée 122 de la seconde structures de couplage 1.

Cette association peut être avantageusement réalisée avec une fibre optique dans son logement de maintien 18 et avec sa membrane d'interfaçage 9 en tant que l'un des deux composants optiques ou optoélectroniques comme représenté en figure 10-b).

L'invention concerne également un procédé de fabrication de structures de couplage optique vertical 1 entre des premiers composants optiques ou optoélectroniques 2 et des seconds composants optiques ou optoélectroniques 3 de taille différente de celle des premiers composants optiques ou optoélectroniques 2, permettant de réaliser un dispositif de couplage collectif monobloc dit matrice.

Lesdites structures de couplage vertical 1 sont réalisées:
- par dépôt d'une couche principale A sur un substrat 35 comprenant des seconds composants optiques ou optoélectroniques dans une étape i ;
- par -lithographie et/ou par gravure physicochimique de la couche principale dans une étape ii.

On entend par couche principale A, une couche qui peut être déformable comme de la résine ou une couche solide comme une plaque de silicium qui est reportée sur le substrat et gravée.

Cette couche principale A est déposée sur tout le substrat et n'est pas logée dans un moule ou autre.

Le terme dépôt concerne aussi bien le dépôt d'une couche malléable sur le substrat que le report correspondant à la mise en place d'une plaque solide par exemple en silicium sur le substrat.

Les structures de couplages optiques sont réalisées dans le volume de cette couche principale de manière collective sur l'ensemble du substrat par technique de lithographie, et avantageusement simultanément. Le motif des structures de couplage est porté au préalable par un masque et est reproduit par lithographie sur la couche principale recouvrant le substrat, assurant ainsi par une action collective une précision commune à chacune des structures de couplage réalisée. Il peut être utilisé notamment une technique de photolithographie pour reporter une couche de masquage sur la couche principale, permettant de poursuivre le transfert du motif du masque sur la couche principale par gravure physico-chimique, le contrôle des angles des flancs de la structure de couplage 1 étant réalisé par les paramètres de contrôles de la gravure.

Il peut être utilisée également une technique de photolithographie directe sur la couche principale lorsque celle-ci est photosensible, le contrôle des angles des flancs de la structure de couplage 1 étant réalisé par le réglage des conditions de sur-/sous-exposition et de sur-/sous-développement.

Le motif peut être également réalisé au préalable sur une estampe, possiblement réalisé par l'une des deux précédentes techniques, qui est appliquée sur la couche principale par tamponnage afin de former la structure de couplage. Il s'agit d'une technique d'estampe à l'échelle du micron ou du nanomètre également appelée en anglais Nano-Imprint-Lithographie (NIL). Chacune de ces techniques assurent la réalisation collective de la structure de couplage 1 avec une précision à l'échelle du micron voir du nanomètre égale sur l'ensemble du wafer.

Chaque structure de couplage optique vertical 1 est réalisée pour être située en regard et en contact d'un second composant optique 31 situé dans le substrat 35.

La couche principale monobloc après l'étape ii comporte des parties de couplage 12 de forme générale tronconique constituées d'un matériau présentant un indice de réfraction supérieur à l'indice de réfraction de l'air.

Les parties de couplage 12 présentant chacune une première surface 121 transversale d'extrémité destinée à être en contact avec la surface d'émission ou de réception 21 d'un premier composant optique ou optoélectronique 2, et une deuxième surface transversale d'extrémité 122 qui est en contact avec la surface d'émission ou de réception 31 du second composant optique ou optoélectronique 3.

En d'autres termes , le procédé permet par la dépose d'une couche principale A dans une étape i et le façonnage de cette couche principale A dans une étape ii d'obtenir des structures de couplage directement réalisés sur des composants optiques, en étant très précis dans leur dimensionnement les unes par rapport aux autres, et ce pour des petites dimensions de composants optiques.

Avantageusement, les premiers composants sont des fibres optiques et les seconds composants sont des dispositifs optiques, des sources ou des détecteurs.

Dans une réalisation la couche principale monobloc comporte la structure de maintien de la fibre 18 présentant en son centre un logement cylindrique 17 adapté pour recevoir une extrémité de la fibre optique 2.

Le nombre minimal et les dimensions des bras (pour éviter les pertes optiques qui sont réalisées dans les bras) dépendent notamment de l'angle θ de la partie tronconique de couplage par rapport à la verticale.

Dans une réalisation, il peut ne pas y avoir de bras, la partie de couplage tronconique du fait de ses dimensions (faible angle par rapport à la verticale notamment) reposant par son poids sur le substrat sans besoin de bras.

L'invention permet ainsi de réaliser directement une matrice de structures de couplage (qui sont reliées entre elles et font partie d'un seul et même élément ou bloc dit matrice) couplées au moins avec des seconds composants optiques ou optoélectroniques disposées dans un substrat donné (ces seconds composants forment avec ce substrat une matrice).

Il peut être ensuite rajouté une matrice avec structures de maintien et des premiers composants optiques ou optoélectroniques logés à l'intérieur de ces structures de maintien.

Ou alors en alternative, il peut être coupé la matrice de structures de couplage en sous matrices et ensuite rajouté une matrice avec structures de maintien et des premiers composants optiques ou optoélectroniques éventuellement logés à l'intérieur.

Toutefois il pourrait éventuellement être envisagé d'autres réalisations.

Dans une réalisation, les structures de couplage peuvent être réalisées sur un substrat provisoire, et peuvent en être détachées et séparées de manière collective avant découpe, ou de manière individuelle après découpe.

Dans une réalisation, une structure de couplage 1 peut être isolée, après découpe de chaque structure de couplage 1 de la matrice, et positionnée individuellement de manière mécanique entre deux composants optiques ou optoélectroniques pour lesquels le dispositif réalise le couplage optique, dans une étape ultérieure à la fabrication du dit dispositif de couplage.

Dans une autre réalisation, la matrice de structures de couplage est adaptée de manière collective et mécanique entre deux matrices des premiers et seconds composants optiques ou optoélectroniques pour lesquelles le dispositif réalise le couplage optique, dans une étape ultérieure à la fabrication du dit dispositif de couplage.

L'invention permet aussi de réaliser les formes de structures de couplage que l'on souhaite.

Le procédé de fabrication proposé permet de dimensionner les pentes des cônes, de réaliser des pentes droites ou courbes, ou avec d'autres formes longitudinales (selon la hauteur verticale) des cônes comme souhaité.

Dans une matrice, il est aussi possible d'avoir des formes coniques différentes, des structures de couplage avec un nombre de bras différents, comme dessiné sur les figures 5 et 13.

Les dimensions des sections de contact 121, 122 sont optimisées de façon à maximiser le recouvrement de la distribution transverse du champ optique de sortie du premier composant avec la surface de réception du second composant tout en permettant une variation de positionnement entre la fibre optique et la section de contact 121, et entre le composant optique ou optoélectronique 2 et la section de contact 122.

L'angle θ et la hauteur H du cône sont déterminés de manière à contenir la divergence du faisceau de sortie du composant optique d'émission, et ainsi maximiser l'adaptation d'angle d'acceptance et de mode entre le composant d'émission et le composant de réception.

En d'autres termes, pour un deuxième diamètre donné, à une longueur d'onde donnée, le rapport entre la hauteur et le premier diamètre est déterminé de manière à assurer un couplage optique d'au moins 60% entre les deux composants optiques ou optoélectroniques pour une variation de désalignement entre les deux composants optiques ou optoélectroniques d'au moins 5 micromètres à partir de la valeur de couplage maximal (en plus ou en moins). En d'autres termes, un désalignement total d'au moins 10 micromètres pour un couplage au moins égal à 60%.

La figure suivante 14 illustre le cas d'un couplage entre une fibre optique monomode de 9µm de diamètre de cœur avec un photorécepteur 31 de 5µm de diamètre (correspondant à DW) à la longueur d'onde de 1550nm, en représentant le taux de couplage attendu en fonction du diamètre de la base du cône 121 (correspondant à TWF)en ordonnée et en fonction de la hauteur du cône (correspondant à TH) en abscisse.

Le matériau utilisé est une résine polymère photosensible SU-8. Le diamètre de la face tronquée 122 (correspondant à TWD) est fixé à 5µm de diamètre. Il y est indiqué qu'une dimension de 12µm minimum est requise pour une hauteur de cône minimale de 20µm.

Il est intéressant d'augmenter la dimension de la section 121 afin d'assurer une meilleure tolérance au désalignement de la fibre optique et ainsi assurer un couplage passif plus aisément. La hauteur du cône devra alors être augmentée proportionnellement selon cette courbe. On peut identifier ainsi un angle maximal à respecter.

Le désalignement peut être défini comme la distance horizontale entre du premier composant optique ou optoélectronique 23 et du deuxième composant optique ou optoélectronique 31.

La figure suivante 15 illustre pour les mêmes conditions, et pour une dimension de 20µm de la section 121, une hauteur de la partie de couplage 12 de 25µm, la tolérance à l'écart de positionnement de la fibre optique par rapport au centre de l'axe de la partie de couplage 12.

En présence de la structure de couplage 1, un taux de couplage de plus de 95% est attendu, contre moins de 40% sans, et une tolérance au désalignement de la fibre de plus de +/-5µm à mi-hauteur de courbe, permettant d'assurer le caractère passif de l'alignement par un simple positionnement mécanique de la fibre optique en vis-à-vis de la structure. Il est possible d'augmenter la dimension de la section 121, en respectant les contraintes de dimensions données par la figure précédente pour l'angle et la hauteur du cône.

Les figures suivantes 16 et 17 présentent les résultats obtenus dans le cas d'une section 122 de 10µm de diamètre, compatible avec des photorécepteurs circulaires de 10µm de diamètre.

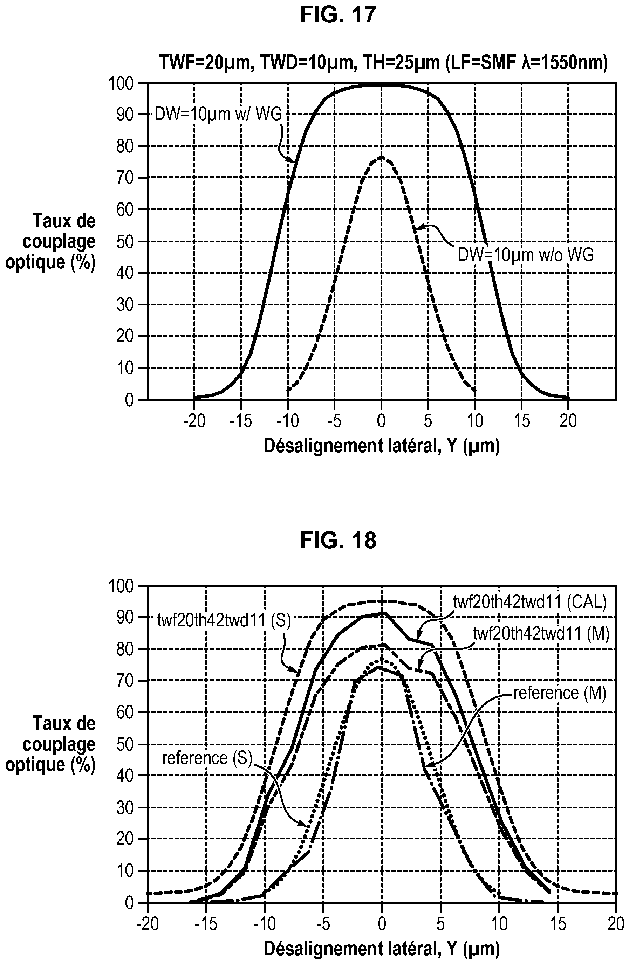

La figure suivante 18 représente les résultats expérimentaux préliminaires obtenus en utilisant une résine SU8 pour coupler une fibre monomode à la longueur d'onde de 1550nm de 9µm de diamètre de cœur. La figure 18 présente les résultats de simulation (S) et de mesure (M) du couplage entre un photorécepteur représenté par un diaphragme de section circulaire de 10µm de diamètre et la fibre, en fonction de l'alignement de la fibre par rapport à l'axe central de la structure de couplage.

La structure de couplage 1 a été choisie selon les courbes précédentes comme ayant une hauteur de 42µm, une section 122 circulaire de 11µm de diamètre et une section circulaire 121 de 20µm de diamètre, sans bras. Les résultats de simulation sont représentés par la courbe twf20th42twd11 (S). Une valeur pic de taux de couplage de près de 95% est obtenu.

Les résultats de mesures sont représentés par la courbe twf20th42twd11 (M).

Pour des raisons expérimentales la fibre et la structure de couplage 1 sont séparées par un intervalle d'air d'environ 10µm dans le sens de la verticale. Cet intervalle occasionne une réflexion à l'interface à la fois de la fibre avec l'air, et de l'air avec la structure de couplage, ainsi qu'une certaine perte d'efficacité. Cette perte sera estompée à la mise en contact et explique la différence entre mesures (M) et simulations (S). Un taux de couplage maximal de près de 80% est démontré dans le cas de cet espace d'air de 10µm.

Un point de mesure est réalisé en mise en contact direct de la fibre avec la structure de couplage optique 1, pour le positionnement de la fibre qui maximise le taux de couplage. Ce point de mesure est repéré par une croix noire isolée avec un taux de couplage qui atteint expérimentalement près de 90%.

Ce résultat est en coïncidence avec les résultats de simulation, et valide l'amélioration du couplage optique par la structure de couplage 1. La courbe twf20th42twd11 (CAL) est calculée en appliqué un facteur de façon à normaliser la courbe twf20th42twd11 (M) mesurée sur le point optimal de couplage en contact direct mesuré.

Elle présente ainsi une estimation pire cas de ce que pourrait être la courbe expérimental final du taux de couplage de la fibre optique au photodétecteur, en condition de contact direct. A mi-hauteur, la courbe démontre expérimentalement une tolérance au désalignement au moins supérieur à +/-8µm. La théorie prédit une tolérance qui pourrait être plus grande si les conditions de mesures permettaient une cartographie en situation de contact permanent garanti.

Il est ainsi démontré expérimentalement l'intérêt de la structure de couplage 1, qui permet d'élargir la tolérance de désalignement de la fibre par rapport au détecteur au-delà de +/-7µm à mi-hauteur, d'une part, et d'améliorer le taux de couplage maximum.

La figure 18 présente aussi en comparaison les simulations (S) et mesures (M) du couplage de ce même diaphragme à la même fibre en l'absence de structure de couplage, constituant une référence pour évaluer l'apport quantitatif de la structure de couplage. Un espace d'air de 10µm est réalisé entre la fibre optique et le diaphragme dans le sens vertical pour les mêmes contraintes de mesures que précédemment. Les simulations en tiennent compte. L'adéquation entre mesures et simulations valide les outils de simulation. Ces résultats confirment également l'intérêt de la présence de la structure de couplage 1 par rapport à une solution de mise en contact direct (butt-coupling) qui demande une précision d'alignement plus importante (tolérance de +/- 5µm à mi-hauteur expérimentalement) pour un taux de couplage maximal plus faible (ici environ 60%).

Cette structure de couplage 1 permet d'atteindre des rendements élevés supérieurs à 50% entre deux dispositifs de dimensions de cœurs ou de surfaces actives réduites, par exemple entre un VCSEL de 10µm de fenêtre optique vers une fibre optique silice de 50µm ou 9µm de diamètre de cœur.

Avec une réduction drastique des manipulations manuelles (positionnement actif de la fibre avec le laser allumé), le coût peut être ramené au seul cout de lithographie du polymère, qui s'intégrerait donc au coût global de fabrication du composant opto-électronique. Alors qu'aujourd'hui le boitier d'un laser coûte 80% du cout du dispositif final, ici l'invention peut permettre de diviser ce cout par au moins un facteur 2.

En terme de performances, il est obtenu des taux de couplage compris entre 60 et 80% avec des tolérances d'alignement de +/-10µm entre un VCSEL de 8µm d'ouverture et une fibre multimode de 50µm de cœur.

## Revendications

1. Procédé de fabrication de structures de couplage optique vertical (1) entre des premiers composants optiques ou optoélectroniques (2) et des seconds composants optiques ou optoélectroniques (3), permettant de réaliser un matrice de couplage collectif monobloc,
lesdites structures de couplage vertical (1) étant réalisées:
- par dépôt d'une couche principale (A) qui est une résine qui présente un caractère adhésif, sur un substrat (35) comprenant des seconds composants optiques ou optoélectroniques (3) dans une étape (i) ;
- par lithographie de la couche principale dans une étape (ii),
chaque structure de couplage optique vertical (1) étant réalisée pour être située en regard et en contact d'un second composant optique (3) situé dans le substrat (35),
la couche principale monobloc comportant des parties de couplage (12) de forme générale tronconique constituées d'un matériau présentant un indice de réfraction supérieur à l'indice de réfraction de l'air après la réalisation de l'étape (ii);
les parties de couplage (12) présentant chacune une première surface (121) transversale d'extrémité destinée à être en contact avec la surface d'émission ou de réception (21) d'un premier composant optique ou optoélectronique (2), et une deuxième surface transversale d'extrémité (122) qui est en contact avec la surface d'émission ou de réception (31) du second composant optique ou optoélectronique (3).

2. Procédé de fabrication selon la revendication 1, **caractérisé en ce que** l'étape (ii) est réalisée par photolithographie.

3. Procédé de fabrication selon la revendication 1 ou 2, **caractérisé en ce que** l'étape (ii) conduit à l'obtention, pour chaque structure de couplage optique verticale (1), d'une partie de support (15) équipée d'un cadre (151) suspendu adapté pour venir en appui sur le substrat (35), et des bras de suspension (152) reliant la partie de couplage (12) au cadre (151).

4. Procédé de fabrication selon l'une des revendications 1 à 3, **caractérisé en ce qu'**une deuxième couche (B) est déposée sur la couche principale (A) au cours d'une étape (iii), cette deuxième couche (B) permettant de réaliser au cours d'une étape (vi) par lithographie des structures de maintien (18) destinées à recevoir un premier composant optique ou optoélectronique (2) dans un logement cylindrique (17).

5. Procédé de fabrication selon la revendication 4, **caractérisé en ce que** des techniques de lithographie par empreinte et/ou de lithographie par nano-empreinte sont utilisées pour réaliser la structure de couplage vertical (1).

6. Procédé de fabrication selon l'une des revendications 1 à 5, **caractérisé en ce que** les premier et second composants optiques ou optoélectroniques (2, 3) sont de dimensions inférieures à 20 µm.

7. Matrice de couplage optique collectif comprenant :
- un substrat (35) avec des deuxièmes composants optiques ou optoélectroniques (3) ayant chacun une surface d'émission ou de réception (31);
- une couche monolithique principale (A) qui est une résine qui présente un caractère adhésif, en contact et adhérée avec le substrat (35),
cette couche monolithique présentant des structures de couplage optique verticales (1),
chaque structure de couplage optique vertical (1) étant réalisée pour être située en regard et en contact d'un second composant optique (3) situé dans le substrat (35),
la couche principale monobloc comportant des parties de couplage (12) de forme générale tronconique constituées d'un matériau présentant un indice de réfraction supérieur à l'indice de réfraction de l'air après la réalisation de l'étape (ii) du procédé de fabrication de la revendication 1, les parties de couplage (12) présentant chacune une première surface (121) transversale d'extrémité destinée à être en contact avec la surface d'émission ou de réception (21) d'un premier composant optique ou optoélectronique (2), et une deuxième surface transversale d'extrémité (122) qui est en contact avec la surface d'émission ou de réception (31) du second composant optique ou optoélectronique (3).

8. Matrice selon la revendication 7, **caractérisée en ce que** des ouvertures permettent d'environner d'air la première surface (121) transversale d'extrémité des parties de couplage (12).

9. Matrice selon l'une des revendications 7 ou 8, dans laquelle le second composant optique ou optoélectronique (3) a une dimension inférieure à 20 µm.

10. Matrice selon l'une des revendications 7 à 9, dans laquelle la couche monolithique principale (A) est une résine polymérisée.

11. Matrice selon l'une des revendications 7 à 10, **caractérisée en ce que** les structures de couplage verticales (1) comprennent des pièces de support (15) monolithiques avec les parties de couplage (12), chacune desdites pièces de support (15) comprenant un cadre suspendu (151) apte à s'appuyer sur le substrat (35), et comprenant en outre des bras de suspension (152) reliant la partie de couplage (12) au cadre (151) et s'étendant radialement depuis la partie de couplage (12),
afin de maintenir par les bras de suspension (152) la partie de couplage (12) en position de couplage par rapport à la surface d'émission ou de réception du second composant optique (31) situé dans le substrat.

12. Matrice selon la revendication 11, **caractérisée en ce que** les bras de suspension (12) sont de section transversale triangulaire, avec un sommet du triangle orienté du côté de la face tronquée de la partie de couplage (12).

13. Matrice selon l'une des revendications 7 à 10, **caractérisée en ce que** les structures de couplage verticales (1) comprennent des parties de couplage (12) sans bras.

14. Dispositif de couplage collectif monobloc comportant :
- des premiers composants optiques ou optoélectroniques (2) présentant chacun une surface d'émission ou de réception (21) ; et
- une matrice selon l'une des revendications 7 à 13,
les structures de couplage comprenant chacune une partie de couplage (12) de forme générale tronconique constituée d'un matériau présentant un indice de réfraction supérieur à l'indice de réfraction de l'air et présentant une hauteur (H) donnée; chaque partie de couplage (12) présentant une première surface transversale (121), présentant un premier diamètre (d1), la première surface transversale (121) étant en contact avec la surface d'émission ou de réception (21) d'un premier composant optique ou optoélectronique (2) ; et une deuxième surface transversale (122), présentant un deuxième diamètre (d2) ;
- pour chaque structure de couplage vertical (1), les dimensions des première et deuxième surfaces transversales (121, 122) sont choisies pour réaliser le recouvrement de la distribution transverse du champ optique de sortie du premier composant optique ou optoélectronique (2) avec la surface d'émission ou de réception (31) du second composant optique ou optoélectronique (3) tout en permettant une variation de positionnement : entre le premier composant optique ou optoélectronique (2) et la première surface transversale (121), et entre le second composant optique ou optoélectronique (32) et la deuxième surface transversale (122),
- la deuxième surface transversale (122) de la partie de couplage (12) étant en contact avec la surface d'émission ou de réception (31) d'un second composant optique ou optoélectronique (3) ;
- pour un deuxième diamètre (d2) donné, à une longueur d'onde donnée d'un faisceau optique, le rapport entre la hauteur (H) et le premier diamètre est déterminé de manière à assurer un couplage optique d'au moins 60% entre le premier composant optique ou optoélectronique (2) et le second composant optique ou optoélectronique (3), pour une variation de désalignement entre les deux composants optiques ou optoélectroniques (2, 3), d'au moins 5 micromètres, en plus ou en moins, par rapport à une position de couplage maximale entre les deux composants optiques ou optoélectroniques (2, 3) .

15. Dispositif selon la revendication 14, dans lequel :
- soit les seconds composants optiques ou optoélectroniques (3) sont des photodétecteurs et les premiers composants optiques ou optoélectroniques (2) sont des fibres optiques monomodes, chaque structure de couplage comportant une première surface transversale (121) supérieure ou égale à la surface d'un cœur (23) de fibre optique monomode et une deuxième surface transversale (122) inférieure ou égale à la surface du second composant optique ou optoélectronique (3) ;
- soit les seconds composants optiques ou optoélectroniques (3) sont des photodétecteurs et les premiers composants optiques ou optoélectroniques (2) sont des fibres optiques multimodes, chaque structure de couplage comportant une première surface transversale (121) supérieure ou égale à la surface d'un cœur (23) de fibre optique multimode et une deuxième surface transversale (122) inférieure ou égale à la surface du second composant optique ou optoélectronique (3).

16. Dispositif selon la revendication 14, dans lequel :
- soit les seconds composants optiques ou optoélectroniques (3) sont des VCSEL et les premiers composants optiques ou optoélectroniques (2) sont des fibres optiques multimodes, chaque structure de couplage comportant une première surface transversale (121) inférieure ou égale à la surface d'un cœur (23) de fibre optique multimode ;
- soit les seconds composants optiques ou optoélectroniques (3) sont des VCSEL, les premiers composants optiques ou optoélectroniques (2) sont des fibres optiques monomodes, chaque structure de couplage comportant une première surface transversale (121) inférieure ou égale à la surface d'un cœur (23) de fibre optique monomode.

17. Dispositif selon la revendication 14, dans lequel :
- soit les seconds composants optiques ou optoélectroniques (3) sont des fibres optiques, les premiers composants optiques ou optoélectroniques (2) sont des fibres optiques ;
- soit les seconds composants optiques ou optoélectroniques (3) sont des lasers VCSEL, respectivement des photodétecteurs, et les premiers composants optiques ou optoélectroniques (2) sont des photodétecteurs, respectivement des lasers VCSEL.

18. Dispositif selon l'une des revendications 14 à 17, **caractérisé en ce que** le dispositif comporte des structures de maintien (18) destinées à recevoir les premiers composants optiques (2) et en appui sur les structures de couplage (1) et les pièces de support (15).

## Patentansprüche

1. Verfahren zur Herstellung vertikaler optischer Kopplungsstrukturen (1) zwischen ersten optischen oder optoelektronischen Komponenten (2) und zweiten optischen oder optoelektronischen Komponenten (3), die erlauben, eine kollektive Einblock-Kopplungsmatrix herzustellen,
wobei die vertikalen Kopplungsstrukturen (1) hergestellt werden:
- durch Aufbringen einer Hauptschicht (A), die ein Harz ist, das einen haftenden Charakter aufweist, auf ein Substrat (35), umfassend zweite optische oder optoelektronische Komponenten (3), in einem Schritt (i) ;
- durch Lithographie der Hauptschicht in einem Schritt (ii),
wobei jede vertikale optische Kopplungsstruktur (1) hergestellt ist, um sich gegenüber und im Kontakt mit einer zweiten optischen Komponente (3) zu befinden, die sich in dem Substrat (35) befindet,
wobei die Einblock-Hauptschicht allgemein kegelstumpfförmige Kopplungsabschnitte (12) aufweist, die aus einem Material bestehen, das einen Brechungsindex aufweist, der höher als der Brechungsindex der Luft nach der Durchführung von Schritt (ii) ist;
wobei jeder Kopplungsabschnitt (12) eine erste transversale Endfläche (121) aufweist, die bestimmt ist, mit der Sende- oder Empfangsfläche (21) einer ersten optischen oder optoelektronischen Komponente (2) im Kontakt zu sein, und eine zweite transversale Endfläche (122), die mit der Sende- oder Empfangsfläche (31) der zweiten optischen oder optoelektronischen Komponente (3) im Kontakt ist.

2. Herstellungsverfahren nach Anspruch 1, **dadurch gekennzeichnet, dass** der Schritt (ii) durch Photolithographie durchgeführt wird.

3. Herstellungsverfahren nach Anspruch 1 oder 2, **dadurch gekennzeichnet, dass** der Schritt (ii) zum Erhalt, für jede vertikale optische Kopplungsstruktur (1), eines Stützabschnitts (15) führt, der mit einem aufgehängten Rahmen (151) ausgestattet ist, der geeignet ist, sich auf dem Substrat (35) abzustützen, und Aufhängungsarmen (152), welche den Kopplungsabschnitt (12) mit dem Rahmen (151) verbinden.

4. Herstellungsverfahren nach einem der Ansprüche 1 bis 3, **dadurch gekennzeichnet, dass** eine zweite Schicht (B) während eines Schritts (iii) auf die Hauptschicht (A) aufgebracht wird, wobei diese zweite Schicht (B) erlaubt, während eines Schritts (vi) durch Lithographie Haltestrukturen (18) herzustellen, die zur Aufnahme einer ersten optischen oder optoelektronischen Komponente (2) in einer zylindrischen Aufnahme (17) bestimmt sind.

5. Herstellungsverfahren nach Anspruch 4, **dadurch gekennzeichnet, dass** Druck- und/oder Nanodrucklithographietechniken verwendet werden, um die vertikale Kopplungsstruktur (1) herzustellen.

6. Herstellungsverfahren nach einem der Ansprüche 1 bis 5, **dadurch gekennzeichnet, dass** die erste und zweite optische oder optoelektronische Komponente (2, 3) Abmessungen unter 20 µm hat.

7. Kollektive optische Kopplungsmatrix, umfassend:
- ein Substrat (35) mit zweiten optischen oder optoelektronischen Komponenten (3), die jeweils eine Sende- oder Empfangsfläche (31) aufweisen;
- eine monolithische Hauptschicht (A), die ein Harz ist, das einen haftenden Charakter aufweist, im Kontakt und haftend mit dem Substrat (35),
wobei diese monolithische Schicht vertikale optische Kopplungsstrukturen (1) aufweist,
wobei jede vertikale optische Kopplungsstruktur (1) hergestellt ist, um sich gegenüber und im Kontakt mit einer zweiten optischen Komponente (3) zu befinden, die sich in dem Substrat (35) befindet,
wobei die Einblock-Hauptschicht allgemein kegelstumpfförmige Kopplungsabschnitte (12) aufweist, die aus einem Material bestehen, das einen Brechungsindex aufweist, der höher als der Brechungsindex der Luft nach der Durchführung von Schritt (ii) des Herstellungsverfahrens nach Anspruch 1 ist,
wobei jeder Kopplungsabschnitt (12) eine erste transversale Endfläche (121) aufweist, die bestimmt ist, mit der Sende- oder Empfangsfläche (21) einer ersten optischen oder optoelektronischen Komponente (2) im Kontakt zu sein, und eine zweite transversale Endfläche (122), die mit der Sende- oder Empfangsfläche (31) der zweiten optischen oder optoelektronischen Komponente (3) im Kontakt ist.

8. Matrix nach Anspruch 7, **dadurch gekennzeichnet, dass** Öffnungen erlauben, die erste transversale Endfläche (121) der Kopplungsabschnitte (12) mit Luft zu umgeben.

9. Matrix nach einem der Ansprüche 7 oder 8, wobei die zweite optische oder optoelektronische Komponente (3) eine Abmessung unter 20 µm hat.

10. Matrix nach einem der Ansprüche 7 bis 9, wobei die monolithische Hauptschicht (A) ein polymerisiertes Harz ist.

11. Matrix nach einem der Ansprüche 7 bis 10, **dadurch gekennzeichnet, dass** die vertikalen Kopplungsstrukturen (1) monolithische Stützteile (15) mit Kopplungsabschnitten (12) umfassen, wobei jedes der Stützteile (15) einen aufgehängten Rahmen (151) umfasst, der geeignet ist, sich auf dem Substrat (35) abzustützen, und ferner Aufhängungsarme (152) umfasst, welche den Kopplungsabschnitt (12) mit dem Rahmen (151) verbinden und sich ab dem Kopplungsabschnitt (12) radial erstrecken,
um durch die Aufhängungsarme (152) den Kopplungsabschnitt (12) in Bezug auf die Sende- oder Empfangsfläche der zweiten optischen Komponente (31), die sich in dem Substrat befindet, in Kopplungsposition zu halten.

12. Matrix nach Anspruch 11, **dadurch gekennzeichnet, dass** die Aufhängungsarme transversal einen dreieckigen Querschnitt haben, mit einer Spitze des Dreiecks, das zur Seite der abgestumpften Fläche des Kopplungsabschnitts (12) zeigt.

13. Matrix nach einem der Ansprüche 7 bis 10, **dadurch gekennzeichnet, dass** die vertikalen Kopplungsstrukturen (1) Kopplungsabschnitte (12) ohne Arme umfassen.

14. Kollektive Einblock-Kopplungsvorrichtung, aufweisend:
- erste optische oder optoelektronische Komponenten (2), die jeweils eine Sende- oder Empfangsfläche (21) aufweisen; und
- eine Matrix nach einem der Ansprüche 7 bis 13,
wobei die Kopplungsstrukturen jeweils einen allgemein kegelstumpfförmigen Kopplungsabschnitt (12) aufweisen, der aus einem Material besteht, das einen Brechungsindex aufweist, der höher als der Brechungsindex der Luft ist und eine gegebene Höhe (H) aufweist;
wobei jeder Kopplungsabschnitt (12) eine erste transversale Fläche (121) aufweist, die einen ersten Durchmesser (d1) aufweist, wobei die erste transversale Fläche (121) mit der Sende- oder Empfangsfläche (21) einer ersten optischen oder optoelektronischen Komponente (2) im Kontakt ist; und eine zweite transversale Fläche (122), die einen zweiten Durchmesser (d2) aufweist;
- wobei für jede vertikale Kopplungsstruktur (1) die Abmessungen der ersten und zweiten transversalen Fläche (121, 122) ausgewählt sind, um die Abdeckung der Querverteilung des optischen Ausgangsfelds der ersten optischen oder optoelektronischen Komponente (2) mit der Sende- oder Empfangsfläche (31) der zweiten optischen oder optoelektronischen Komponente (3) abzudecken, bei Gestattung einer Variation der Positionierung: zwischen der ersten optischen oder optoelektronischen Komponente (2) und der ersten transversalen Fläche (121), und zwischen der zweiten optischen oder optoelektronischen Komponente (32) und der zweiten transversalen Fläche (122),
- wobei die zweite transversale Fläche (122) des Kopplungsabschnitts (12) mit der Sende- oder Empfangsfläche (31) einer zweiten optischen oder optoelektronischen Komponente (3) im Kontakt ist;
- wobei für einen gegebenen zweiten Durchmesser (d2), in einer gegebenen Wellenlänge eines optischen Strahls, das Verhältnis zwischen der Höhe (H) und dem ersten Durchmesser derart bestimmt ist, dass eine optische Kopplung von mindestens 60 % zwischen der ersten optischen oder optoelektronischen Komponente (2) und der zweiten optischen oder optoelektronischen Komponente (3) gesichert ist, für eine Variation der Fehlausrichtung zwischen den zwei optischen oder optoelektronischen Komponenten (2, 3) von mindestens 5 Mikrometer mehr oder weniger in Bezug auf eine maximale Kopplungsposition zwischen den zwei optischen oder optoelektronischen Komponenten (2, 3).

15. Vorrichtung nach Anspruch 14, wobei:
- entweder die zweiten optischen oder optoelektronischen Komponenten (3) Photodetektoren sind und die ersten optischen oder optoelektronischen Komponenten (2) monomodale optische Fasern sind, wobei jede Kopplungsstruktur eine erste transversale Fläche (121) aufweist, die größer als oder gleich der Fläche einer Seele (23) einer monomodalen optischen Faser ist und eine zweite transversale Fläche (122), die kleiner als oder gleich der Fläche der zweiten optischen oder optoelektronischen Komponente (3) ist;
- oder die zweiten optischen oder optoelektronischen Komponenten (3) Photodetektoren sind und die ersten optischen oder optoelektronischen Komponenten (2) multimodale optische Fasern sind, wobei jede Kopplungsstruktur eine erste transversale Fläche (121) aufweist, die größer als oder gleich der Fläche einer Seele (23) einer multimodalen optischen Faser ist und eine zweite transversale Fläche (122), die kleiner als oder gleich der Fläche der zweiten optischen oder optoelektronischen Komponente (3) ist.

16. Vorrichtung nach Anspruch 14, wobei:
- entweder die zweiten optischen oder optoelektronischen Komponenten (3) VCSEL sind und die ersten optischen oder optoelektronischen Komponenten (2) multimodale optische Fasern sind, wobei jede Kopplungsstruktur eine erste transversale Fläche (121) aufweist, die kleiner als oder gleich der Fläche einer Seele (23) einer multimodalen optischen Faser ist;
- oder die zweiten optischen oder optoelektronischen Komponenten (3) VCSEL sind, die ersten optischen oder optoelektronischen Komponenten (2) monomodale optische Fasern sind, wobei jede Kopplungsstruktur eine erste transversale Fläche (121) aufweist, die kleiner als oder gleich der Fläche einer Seele (23) einer monomodalen optischen Faser ist.

17. Vorrichtung nach Anspruch 14, wobei:
- entweder die zweiten optischen oder optoelektronischen Komponenten (3) optische Fasern sind, die ersten optischen oder optoelektronischen Komponenten (2) optische Fasern sind;
- oder die zweiten optischen oder optoelektronischen Komponenten (3) VCSEL-Laser beziehungsweise Photodetektoren sind, und die ersten optischen oder optoelektronischen Komponenten (2) Photodetektoren beziehungsweise VCSEL-Laser sind.

18. Vorrichtung nach einem der Ansprüche 14 bis 17, **dadurch gekennzeichnet, dass** die Vorrichtung Haltestrukturen (18) aufweist, die zur Aufnahme der ersten optischen Komponenten (2) bestimmt sind und in Abstützung auf den Kopplungsstrukturen (1) und den Stützteilen (15).

## Claims

1. A method for manufacturing vertical optical coupling structures (1) between first optical or optoelectronic components (2) and second optical or optoelectronic components (3), making it possible to produce a monolithic collective coupling matrix,
said vertical coupling structures (1) being produced:
- by depositing a main layer (A) which is resin having an adhesive nature, onto a substrate (35) comprising second optical or optoelectronic components (3) in a step (i);
- by lithography of the main layer in a step (ii),
each vertical optical coupling structure (1) being produced to be located facing and in contact with a second optical component (3) located in the substrate(35),
the monolithic main layer including coupling parts (12) of an overall truncated cone shape composed of a material with a refractive index greater than the refractive index of air after performing step (ii);
the coupling parts (12) each having a first transverse end surface (121) intended to be in contact with the emission or reception surface (21) of a first optical or optoelectronic component (2), and a second transverse end surface (122) which is in contact with the emission or reception surface (31) of the second optical or optoelectronic component (3).

2. The manufacturing method according to claim 1, **characterized in that** the step (ii) is carried out by photolithography.

3. The manufacturing method according to claim 1 or 2, **characterized in that** the step (ii) leads to the obtaining, for each vertical optical coupling structure (1), of a support part (15) equipped with a suspended frame (151) suitable for bearing on the substrate (35), and suspension arms (152) connecting the coupling part (12) to the frame (151).

4. The manufacturing method according to one of claims 1 to 3, **characterized in that** a second layer (B) is deposited onto the main layer (A) in a step (iii), this second layer (B) making it possible to produce in a step (vi), by lithography of the holding structures (18) intended to receive a first optical or optoelectronic component (2) in a cylindrical housing (17) .

5. The manufacturing method according to claim 4, **characterized in that** imprint lithography and/or nano-imprint lithography techniques are used to produce the vertical coupling structure (1).

6. The manufacturing method according to one of claims 1 to 5, **characterized in that** the first and second optical or optoelectronic components (2, 3) have dimensions of less than 20 µm.

7. A collective optical coupling matrix comprising:
- a substrate (35) with second optical or optoelectronic components (3) each having an emission or reception surface (31);
- a monolithic main layer (A) which is a resin having an adhesive nature, in contact and adhering with the substrate (35),
this monolithic layer having vertical optical coupling structures (1),
each vertical optical coupling structure (1) being produced to be located facing and in contact with a second optical component (3) located in the substrate (35),
the monolithic main layer including coupling parts (12) of an overall truncated cone shape composed of a material with a refractive index greater than the refractive index of air after performing step (ii) of the manufacturing method of claim 1,
the coupling parts (12) each having a first transverse end surface (121) intended to be in contact with the emission or reception surface (21) of a first optical or optoelectronic component (2), and a second transverse end surface (122) which is in contact with the emission or reception surface (31) of the second optical or optoelectronic component (3).

8. A matrix according to claim 7, **characterized in that** apertures allow surrounding with air the first transverse end surface (121) of the coupling parts (12) .

9. The matrix according to one of claims 7 or 8, wherein the second optical or optoelectronic component (3) has a dimension of less than 20 µm.

10. The matrix according to one of claims 7 to 9, wherein the monolithic main layer (A) is a polymer resin.

11. The matrix according to one of claims 7 to 10, **characterized in that** the vertical coupling structures (1) comprise monolithic support parts (15) with the coupling parts (12), each of said support part (15) comprising a suspended frame (151) suitable for bearing on the substrate (35), and further comprising suspension arms (152) connecting the coupling part (12) to the frame (151) and extending radially from the coupling part (12),
in order to hold by the suspension arms (152) the coupling part (12) in the coupling position in relation to the emission or reception surface of the second optical component (31) located in the substrate.

12. The matrix according to claim 11, **characterized in that** the suspension arms are of triangular cross section, with one apex of the triangle oriented on the side of the truncated face of the coupling part (12).

13. The matrix according to one of claims 7 to 10, **characterized in that** the vertical coupling structures (1) comprise coupling parts (12) without arms.

14. A monolithic collective coupling device including:
- first optical or optoelectronic components (2) each having an emission or reception surface (12); and
- a matrix according to one of claims 7 to 13,
the coupling structures each comprising a coupling part (12) of an overall truncated cone shape composed of a material with a refractive index greater than the refractive index of air and having a given height (H);
each coupling part (12) having a first transverse surface (121), having a first diameter (d1), the first transverse surface (121) being in contact with the emission or reception surface (21) of a first optical or optoelectronic component(2); and a second transverse surface (122), having a second diameter (d2);
- for each vertical coupling structure (1), the dimensions of the first and second transverse surfaces (121, 122) are chosen to produce overlapping of the transverse distribution of the output optical field of the first optical or optoelectronic component (2) with the emission or reception surface (31) of the second optical or optoelectronic component (3) while allowing a variation in the positioning: between the first optical or optoelectronic component (2) and the first transverse surface (121), and between the second optical or optoelectronic component (32) and the second transverse surface (122),
- the second transverse surface (122) of the coupling part (12) being in contact with the emission or reception surface (31) of a second optical or optoelectronic component (3);
- for a given second diameter (d2), at a given wavelength of an optical beam, the ratio of the height (H) to the first diameter is determined in such a way as to provide optical coupling of at least 60% between the first optical or optoelectronic component (2) and the second optical or optoelectronic component (3), for a variation of misalignment between the two optical or optoelectronic components (2, 3), of at least 5 micrometers, more or less, in relation to a position of maximum coupling between the two optical or optoelectronic components (2,3).

15. The device according to claim 14, wherein:
- either the second optical or optoelectronic components (3) are photodetectors and the first optical or optoelectronic components (2) are single-mode optical fibers, each coupling structure including a first transverse surface (121) greater than or equal to the surface of a single-mode optical fiber core (23) and a second transverse surface (122) smaller than or equal to the surface of the second optical or optoelectronic component (3);
- or the second optical or optoelectronic components (3) are photodetectors and the first optical or optoelectronic components (2) are multi-mode optical fibers, each coupling structure including a first transverse surface (121) greater than or equal to the surface of a multi-mode optical fiber core (23) and a second transverse surface (122) smaller than or equal to the surface of the second optical or optoelectronic component (3).

16. The device according to claim 14, wherein:
- either the second optical or optoelectronic components (3) are VCSELs and the first optical or optoelectronic components (2) are multi-mode optical fibers, each coupling structure including a first transverse surface (121) smaller than or equal to the surface of a multi-mode optical fiber core (23);
- or the second optical or optoelectronic components (3) are VCSELs, the first optical or optoelectronic components (2) are single-mode optical fibers, each coupling structure including a first transverse surface (121) smaller than or equal to the surface of a single-mode optical fiber core (23).

17. The device according to claim 14, wherein:
- either the second optical or optoelectronic components (3) are optical fibers, the first optical or optoelectronic components (2) are optical fibers;
- or the second optical or optoelectronic components (3) are VCSEL lasers, respectively photodetectors, and the first optical or optoelectronic components (2) are photodetectors, respectively VCSEL lasers.

18. The device according to one of claims 14 to 17, **characterized in that** the device includes holding structures (18) intended to receive the first optical components (2) and bearing on the coupling structures (1) and the support parts (15).
